# EUROPÄISCHE PATENTANMELDUNG

(11) **EP 0 810 446 A2**
(43) Veröffentlichungstag der Anmeldung: **03.12.1997**
(21) Anmeldenummer: 97108171.6
(22) Anmeldetag: 20.05.1997
(51) Int. Cl.: G01R 31/04, G01R 31/28

(54) **Testverfahren zur Prüfung von Baugruppenverbindungen**

(30) Priorität: 31.05.1996 DE 19622009
(71) Anmelder: SIEMENS AKTIENGESELLSCHAFT, 80333 München (DE)
(72) Erfinder: Brand, Uwe, Dipl.-Ing. (FH), 81829 München (DE); Zellerhoff, Thomas, Dipl.-Ing., 81371 München (DE)

(57) **Zusammenfassung**

Verfahren zur Prüfung von Baugruppenverbindungen, wobei ein

nominelles Abschlußpotential wahlweise von einem ersten oder zweiten Abschlußwiderstand abgetrennt und dafür ein erstes oder zweites Prüfpotential an den ersten oder zweiten Abschlußwiderstand angelegt wird.

## Beschreibung

Die Erfindung betrifft ein Verfahren gemäß dem Oberbegriff des Patentanspruchs 1.

In Vermittlungsanlagen werden in Baugruppen /Baugruppeneinheiten Differenzstufen in Eingangs- und Ausgangseinheiten eingesetzt und die Verbindungsleitungen zwischen diesen an einem gemeinsamen Abschlußpotential angeschlossen.
Um Baugruppeneinheiten bzw. Verbindungen zwischen den Baugruppen zu testen, werden bereits in der Fertigung zunehmend automatisierte Prüfverfahren zur Sicherung der Produktqualität verwendet. Als bekannte Prüfungsverfahren wären hierzu der Boundary Scan, der Board Self Test und der In Circuit Test aufzuführen.
Der Board Self Test ist ein Testverfahren, das mit Hilfe eines Prozessors, der auf einer der zu prüfenden Baugruppen angeordnet ist, durchgeführt wird. Im Prozessor werden dazu Prüfprogramme abgearbeitet, welche sich in Speichereinheiten, auf die der Prozessor Zugriff hat, befinden. Der Board Self Test kann für die Prüfung von Baugruppen einzeln oder bei Inbetriebnahme von Baugruppen eines Systems verwendet werden. Im Fehlerfall liefert der Board Self Test entsprechende Hinweise.
Bei dem Boundary Scan werden auf Baugruppen Verbindungstests zwischen integrierten Schaltungen und deren Umgebung und interne Tests in den integrierten Schaltungen durchgeführt. Mit dem Boundary Scan können einzelne Prüfzugriffe eines In Circuit Tests reduziert werden. Bei einem In Circuit Test wird jeweils das einzelne Bauelement auf der Baugruppe geprüft. Analoge Bauelemente wie Widerstände, Induktivitäten und Kapazitäten sowie aktive Bauelemente wie Transistoren und Dioden werden auf Einhaltung ihrer vorbestimmten Werte überprüft. Bei integrierten Schaltkreisen werden die Beschaltungsanschlüsse primär mit Hilfe eines Testmodells (Prüfbitmuster) geprüft. Dabei werden zumindest die Grundfunktionen des Bausteins getestet. Für dieses Testverfahren ist jedoch eine Vorleistung zu erbringen, die darin besteht, daß für den Zeitraum des Tests das zu prüfende Bauelement oder die Bauelementeeinheit von der sie umgebenden Schaltung isoliert werden muß.
Dies kann mit Hilfe eines Nadeladapters erreicht werden. Der durch den Nadeladapter isolierte integrierte Baustein kann in sehr kurzer Zeit auf Kurzschlüsse, Unterbrechungen, Fehlbestückungen und statische Bauelementefehler mit dem Boundary Scan Test geprüft werden.

Im Idealfall wird die gesamte Prüfung der digitalen Schaltungen allein durch einen Boundary Scan Tester ohne Nadeladapter durchgeführt. Dieses Testverfahren kann sowohl für eine einzelne integrierte Schaltung als auch auf ganze Systemeinheiten durchgeführt werden. Zur Durchführung dieses Verfahrens sind Hilfsschaltungen, daß heißt Trenngatter, auf den IC 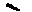 s vor den Ein- und nach den Ausgängen implementiert, die im Testmodus während oder nach der Fertigung eine Verifikation von elektrischen Verbindungen ermöglicht.

Die für das Boundary-Scan Testverfahren erforderlichen Trenngatter können bei einem hoch-bitratigen Datenaustausch über Doppelader-Verbindungsleitungen nur nach den Ein- bzw. vor den Ausgangsstufen angeordnet sein, um die Qualität der übertagenen Signale nicht zu beeinträchtigen.
Technologiebedingte Offsetspannungen führen unter Umständen dazu, daß Leitungsfehler nicht erkannt werden, wenn eine der beiden Adern des Adernpaares unterbrochen ist. Die Baugruppe würde den Test ohne Fehler durchlaufen, obwohl eine korrekte Funktion im System, z.B. bei anderen umweltbedingten Betriebsbedingungen nicht sichergestellt ist. Eine dann notwendig werdende Fehlersuche im Vermittlungssystem ist überaus aufwendig und kostspielig.

Aufgabe der Erfindung ist es, ein Verfahren zum Testen von Doppelader-Verbindungsleitungen zwischen Baugruppen anzugeben.

Die Aufgabe wird durch die Merkmale des Patentanspruchs 1 gelöst.

Das Verfahren weist den Vorteil auf, daß insbesondere bei hohen Übertragungsraten mit differentiellen Signalen komplett bestückte Baugruppen abschließend getestet werden können.

Das Verfahren bringt den Vorteil mit sich, daß die zu messenden Leitungen nicht über einzelne Nadeln, Nadelkissen oder kapazitive Sonden kontaktiert werden müssen.

Ein weiterer Vorteil dieses Verfahrens ist, daß es einfach zu handhaben ist und daß mögliche Fehler sicher und gezielt ermittelt werden können.

Weitere Besonderheiten der Erfindung werden aus der nachfolgenden näheren Erläuterung eines Ausführungsbeispiels anhand einer Zeichnung ersichtlich.

Betrachtet wird eine Leitungsführung, bestehend aus einem Adernpaar zwischen zwei Baugruppen oder Baugruppeneinheiten BA, BB. Bei einer schnellen Datenübertragung werden vorzugsweise die Daten über die Ader L1, L2 durch eine digitale Datenfolge auf der Ader L1 und einer dazu zeitgleich übertragenen komplementären Datenfolge auf der Ader L2 übertragen. Die Ader L1 und L2 ist empfangsseitig jeweils mit einem bausteinexternen Widerstand W1, W2 abgeschlossen. Wenn integrierte Abschlußwiderstände W1, W2 eingesetzt werden, sollten die Abschlußpotentiale für die invertierenden und nichtinvertierenden Eingänge getrennt zugänglich sein. Die Widerstände W1, W2 bilden gleichzeitig einen wellenwiderstandsmäßigen Abschluß der Adern L1, L2.

Die Eingangsstufe BE des angesteuerten integrierten Schaltkreises ICB kann aufgrund von technologiebedingten Toleranzen eine Offsetspannung von ΔU aufweisen, d.h. nur Eingangssignale mit einer Differenzspannung > ΔU werden richtig erkannt.
Die Ausgangsstufe des treibenden Abschlußbausteins AS ist so dimensioniert, daß unabhängig vom Spannungspotential am Ausgang der Treiberstufe Aa, Ab durch Verschieben des Abschlußpotentials um > ΔU ein eindeutiges Signal eingeprägt werden kann.

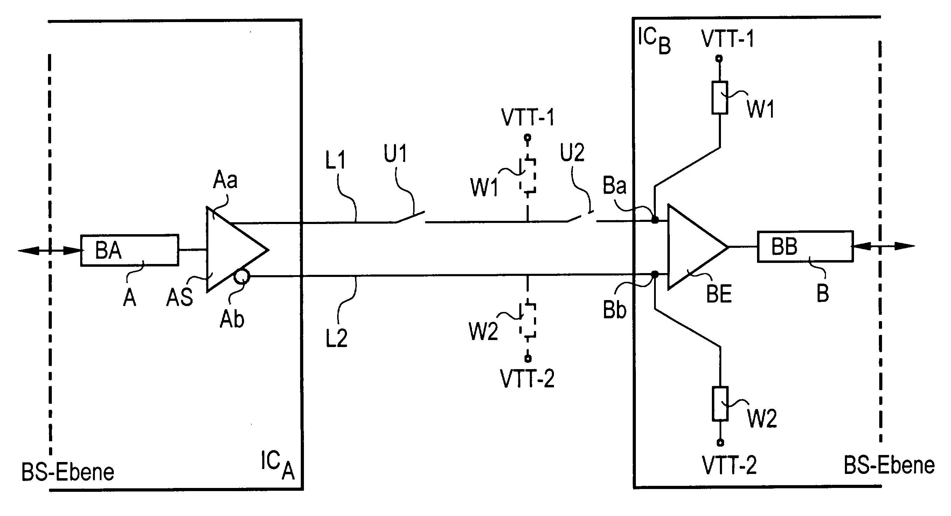

Die Zeichnung zeigt schematisch eine Anordnung von zwei Baugruppen. Diese Baugruppen sind der Übersicht halber nur mit einem Adernpaar, bestehend aus den Adern L1, L2 zwischen zwei Leitungsendpunkten A, B verbunden. Diese Leitungsendpunkte bilden jeweils Zellen oder Trenngatter BA, BB in den integrierten Schaltkreisen ICA und ICB. Der jeweilige Leitungsabschluß AS, BE ist beispielsweise aus jeweils einer Differenzstufe gebildet. Ausgehend von der Bausteinzelle BA wird das von der integrierten Schaltung abgegebene Signal an den Eingang eines Leitungstreibers AS weitergeleitet. Über die Trenngatter können ebenso beliebige Signalfolgen auf den Treibereingang gegeben werden. An den Ausgang des Leitungstreibers AS wird eine komplementäre Signalfolge auf das Adernpaar L1, L2 gegeben. Die genannte Leitungsführung ist auch als differentielle Leitungsführung bekannt und verbindet die Ausgänge einer Leitungstreibereinheit AS mit den Eingängen einer Leitungstreibereinheit BE. Die Widerstände W1, W2 bilden einen wellenwiderstandsmäßigen Leitungsabschluß. Diese Abschlußwiderstände W1, W2 können beispielsweise auch durch bausteinexterne Widerstände, wie in der schematischen Darstellung angedeutet, gebildet werden.
Die in der Zeichnung dargestellte Leitungsführung zwischen den Baueinheiten ICA und ICB, ist beispielsweise an einer Stelle U1 oder U2 auf der Verbindungsleitung L1 zwischen den integrierten Schaltkreisen unterbrochen. Zur Ermittlung einer Leitungsstörung und Behebung der Leitungsunterbrechung werden erfindungsgemäß an die externen oder internen Abschlußwiderstände während des Prüfverfahrens unterschiedliche Prüfpotentiale VTT, VTT ± ΔU₁ und VTT ± ΔU₂ an die Abschlußwiderstände W1 und W2 angelegt. Die Höhe der zeitweilig an den Leitungen, beziehungsweise an den Treibereingängen Ba, Bb anliegenden Prüfpotentiale VTT, VTT ± ΔU₁ und VTT ± ΔU₂ kann zur Leitungsmessung beziehungsweise zur Fehlerortung entsprechend einer IC-Spezifikation (ECL, CML) gewählt werden.
Zum Leitungstest werden die Prüfpotentiale gegeneinander verschoben. Bei dem unterschiedlich hoch eingestellten ersten und zweiten Prüfpotential VTT1 (VTT ± ΔU₁), VTT2 (VTT ± ΔU₂) kann eine Leitungsunterbrechung festgestellt und lokalisiert werden. In der nachfolgenden Tabelle 1 ist dazu der Meßablauf dargestellt. Bei niederohmigen Ausgängen sind entsprechend höhere Spannungen an die Leitungen anzulegen.

Ausgehend von einem im normalem Betrieb an den Adern L1, L2, bedingt durch die jeweilige Schaltungstechnik, anliegenden nominellen Abschlußpotential VTT, wird eine physikalische Verbindung die eine Verbindung mit dem genannten Potential ermöglicht vor der Meßprozedur aufgetrennt. Entsprechend der Meßprozedur (Tabelle 1, 2, Fall 1-4) werden dann unterschiedlich hohe Prüfpotentiale VTT ± ΔU₁, ± ΔU₂ beispielsweise über die externen Abschlußwiderstände W1, W2 an die Leitungsabschnitte oder an die aus jeweils einer Ader L1, L2 gebildeten Übertragungsleitung angelegt.

### Tabelle 1 zeigt den Meßablauf:

| Fall | angelegtes Prüfpotential VTT,VTT1, VTT1 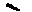 , VTT2, VTT2 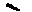 ,an W1 -erstes Prüfpotential | angelegtes Prüfpotential VTT,VTT1, VTT1 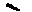 , VTT2, VTT2 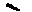 ,an W2 -zweites Prüfpotential | Boundary-Scan Ergebnis: Ein Fehler liegt vor bei Nichterkennen: | Fehlerursache |
|---|---|---|---|---|
| 1 | VTT ± ΔU₂ (VTT2, VTT2 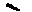 ) | VTT | des über VTT eingeprägten Pegelwechsels im angesteuerten Baustein. | Leitung 1 oder 2 zwischen Abschlußwiderstand und Empfängerbaustein unterbrochen |
| 2 | VTT | VTT ± ΔU₂ (VTT2, VTT2 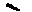 ) | des über VTT eingeprägten Pegelwechsel im angesteuerten Baustein. | Leitung 1 oder 2 zwischen Abschlußwiderstand und Empfängerbaustein unterbrochen |
| 3 | VTT ± ΔU₁ (VTT1, VTT1 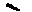 ) | VTT | eines Pegelwechsels des treibenden Bausteins. | Leitungsunterbrechung der Leitung 1 oder 2 zwischen treibendem Baustein und Abschlußwiderstand |
| 4 | VTT | VTT ± ΔU₁ (VTT1, VTT1 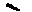 ) | eines Pegelwechsels des treibenden Bausteins. | Leitungsunterbrechung der Leitung 1 oder 2 zwischen treibendem Baustein und Abschlußwiderstand |

Welche Signalader unterbrochen ist, läßt sich durch eine erste oder zweite Messung wie in Tabelle 2 angegeben feststellen.

**Tabelle 2**

| Messung 1 (Fall 1) | Messung 2 (Fall 2) | Fehlerort |
|---|---|---|
| Pegelübergang erkannt | Pegelübergang nicht erkannt | Leitung 2 zwischen Abschlußwiderstand und Eingang unterbrochen |
| Pegelübergang nicht erkannt | Pegelübergang erkannt | Leitung 1 zwischen Abschlußwiderstand und Eingang unterbrochen |

Bei einem Test wird beispielsweise am Eingang des Leitungstreibers BE eine digitale Signalfolge gezielt oder über den Boundary-Scan eingeprägt. Am ersten Eingang Ba der Empfangsstufe BE liegen dann die Spannungspegel der Signalfolge und das über den Abschlußwiderstand W1 eingeprägtes Prüfpotential VTT1 oder VTT1 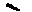 . Am zweiten Eingang Bb der Empfängerstufe BE wird lediglich die zum Eingangssignal komplementäre Signalfolge empfangen, da der zweite Abschlußwiderstand W2 in dieser Testphase an einem nominellen Abschlußpotential VTT beaufschlagt ist. Eine Subtraktion der an den Eingängen Ba, Bb der Empfangsstufe BE anliegenden Potentiale ergibt eine Signalfolge, die zwischen den Ausgangsspannungen der Treiberstufe AS entsprechend der am Eingang angelegten Signalfolge wechselt. Diese Signalfolge ist mit dem wechselnden Prüfpotential VTT1, das über den ersten Wellenwiderstand eingeprägt ist, überlagert.
Bei einem Bruch der Verbindungsader L1 liegt lediglich das über den Abschlußwiderstand W1 eingeprägte wechselnde Prüfpotential VTT1, VTT1 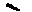 am Eingang Ba der Empfangsstufe BE. Bei einer Subtraktion der beiden am Eingang Ba, Bb anliegenden Potentiale ergibt sich am Ausgang der Empfängerstufe BE ein deutlich veränderter Signalverlauf gegenüber einer störungsfreien Datenübertragung. Das über den Abschlußwiderstand eingeprägte Potential muß größer als die Offsetspannung aber jedoch kleiner als die Spannungsdifferenz des am Ausgang des Treibers AS abgreifbaren Potentials sein.

Bei einem Leitungsbruch zwischen Treiberbaustein und Abschlußwiderstand ist eine Fehlerlokalisierung nur dann möglich, wenn das Vorzeichen der Offsetspannung ± ΔU₁, ± ΔU₂ des angesteuerten Eingangs bekannt ist.

Das Verfahren bringt den Vorteil mit sich, daß auch differentielle Leitungen auf einer komplett bestückten Baugruppe zu 100% geprüft werden können, ohne die zu messenden Leitungen über Prober oder Nadelkissen kontaktieren zu müssen. Lediglich die Prüfpotentiale VTT1 und VTT2 müssen während des Meßablaufes mit einstellbaren Potentialen beaufschlagt werden. Nach Abschluß der Messung werden VTT1 und VTT2 gemeinsam an VTT angeschlossen. Wenn die Prüfpotentiale VTT1 und VTT2 mittels Potentialebenen realisiert werden, ist keine Beeinträchtigung der HF-Eigenschaften der Verbindungen zu befürchten.

Werden diese in der Tabelle 1 aufgeführten Verfahrensschritte auch beim BOST-Verfahren durchgeführt, so können damit Fehler initiiert und dadurch ebenfalls Leitungsstörungen erkannt werden.

## Patentansprüche

1. Verfahren zur Ermittlung von Leitungsstörungen, insbesondere einer Adernunterbrechung (U1, U2), bei einem aus einer ersten und zweiten Ader (L1, L2) gebildeten Leitungspaar, das zwei Baugruppeneinheiten (ICA, ICB) verbindet, und die Adern (L1, L2) empfangsseitig einen ersten Widerstand (W1) an der ersten Ader (L1) und einen zweiten Widerstand (W2) an der zweiten Ader aufweisen, die an einem gemeinsamen Abschlußpotential anliegen,
**dadurch gekennzeichnet**,
daß ein zu übertragendes Signal über die erste Ader (L1) und das komplementäre Signal zeitgleich über die zweite Ader (L2) übertragen wird,
daß während der Prüfphase der erste oder zweite Widerstand (W1, W2) vom gemeinsamen Abschlußpotential (VTT) getrennt und der erste oder zweite Widerstand (W1, W2) mit mindestens einem von dem Abschlußpotential verschiedenen Prüfpotential(VTT1, VTT2) verbunden wird und
daß aus einem durch Subtraktion zwischen den empfangenen Signalen auf der ersten und zweiten Ader (L1, L2), wobei mindestens ein Signal mit dem Prüfpotential (VTT1, VTT2) überlagert ist, eine Signalfolge gebildet und bei einer Leitungsstörung ein geänderter Signalverlauf bei der Signalfolge erkannt wird.

2. Verfahren nach Anspruch 1,
**dadurch gekennzeichnet**,
- daß in einem ersten Verfahrensschritt ein erstes Prüfpotential (VTT1) an den ersten Widerstand (W1) während an den zweiten Widerstand (W2) das Abschlußpotential (VTT) angelegt wird,
- daß in einem zweiten Verfahrensschritt das erste Prüfpotential (VTT1) an den zweiten Widerstand (W2) und das Abschlußpotential (VTT) an den ersten Widerstand (W1) angelegt wird.

3. Verfahren nach Anspruch 2,
**dadurch gekennzeichnet,**
- daß in einem nachfolgenden dritten und vierten Verfahrensschritt entsprechend dem ersten und zweiten Verfahrensschritt ein zweites Prüfpotential (VTT2) an den ersten und zweiten Widerstand (W1, W2) angelegt werden, während der jeweils andere Widerstand (W1, W2) mit einem, dem Abschlußpotential (VTT) beaufschlagt wird.

4. Verfahren nach Anspruch 1,
**dadurch gekennzeichnet**,
daß das erste und zweite Prüfpotential (VTT1, VTT2) jeweils mindestens einen Prüfpotentialwert annehmen kann.

5. Verfahren nach Anspruch 1,
**dadurch gekennzeichnet**,
daß eine digitale Signalfolge an einem Treibereingang (AS) eingeprägt wird und die erste und zweite Ader (L1, L2) mit den Ausgängen eines Treibers (AS) verbunden sind.

6. Verfahren nach Anspruch 1,
**dadurch gekennzeichnet**,
daß die Verbindungsadern (L1, L2) mit einem internen Widerstand (W1, W2) in einem integrierten Schaltkreis (ICB) abgeschlossen werden können.

7. Verfahren nach Anspruch 1,
**dadurch gekennzeichnet**,
daß der erste und zweite Widerstand (W1, W2) einen wellenwiderstandsmäßigen Leitungsabschluß bildet.
